# EUROPEAN PATENT APPLICATION

(11) **EP 3 933 949 A1**
(43) Date of publication of application: **05.01.2022**
(21) Application number: 20183080.9
(22) Date of filing: 30.06.2020
(51) Int. Cl.: H01L 51/46, C08G 61/00, C08G 73/00

(54) **COMPOSITION COMPRISING AN ORGANIC SEMICONDUCTING POLYMER AND A CROSSLINKING AGENT AND ORGANIC PHOTODIODE THEREOF**

(71) Applicant: BASF SE, 67056 Ludwigshafen am Rhein (DE)
(72) Inventor: Wu, Anju, 16419 Suwon (KR); Lin, Wei Hsiang, 16342 Suwon-si, Gyeonggi-do (KR); Schroeder, Marc, 10245 Berlin (DE); Na, Geumbi, Seoul (KR)
(74) Representative: BASF IP Association

(57) **Abstract**

The invention relates to a composition used for electron blocking layer, which comprises an organic semiconducting polymer and a crosslinking agent, wherein the organic semiconducting polymer and the crosslinking agent can undergo crosslinking reaction under thermal and/or light exposure. The present invention also provides an organic photodiode, which comprises an electron blocking layer made from said composition. By using the composition according to the present invention to form the electron blocking layer, organic electronic device comprising the electron blocking layer has greatly reduced dark current level.

## Description

### TECHNICAL FIELD

The present invention relates to a composition used for electron blocking layer of organic photodiode, and also relates to organic photodiode comprising an electron blocking layer formed by such composition.

### BACKGROUND ART

Organic photodiode is used in a wide range of applications for being light weight, flexible and easily tunable in its organic molecular characteristics. It compensates for the shortcomings of its inorganic counterpart. Organic photodiodes utilizing p type organic donors blended with n type organic acceptors to form the bulk heterojunction active layer, which enables better photon conversion and detectivity of the devices. However, high dark current level and reliability of organic photodiodes have hindered their use for sophisticated applications.

US8399761 B2 discloses an organic photovoltaic device with interfacial layer and method of fabricating same. The interfacial layer comprises 5,5'-bis[(p-trichlorosilylpropylphenyl)phenylamino]-2,2'-bithiophene (PABTSi2) which is crosslinked. The overall performance of the photovoltaic device is improved.

US 2009/0302311A1 discloses polymers which can be used as organic semiconductor in organic devices, such as organic diodes. The polymers used in semiconductor devices or organic photovoltaic devices can lead to high efficiency of energy conversion, excellent field-effect mobility, good on/off current ratios and/or excellent stability.

WO 2015/004563 discloses crosslinkers which can be used for preparing polymer layer in electronic devices. The crosslinkers can absorb radiation at the same wavelength as that used for the photoresist-layer, so that the preparation process can be conducted in a convenient way.

However, combined use of the polymers and crosslinkers has not been disclosed in the prior art. Moreover, it is desired to provide organic photodiodes which have reduced dark current level.

### CONTENTS OF THE INVENTION

It is an object of the present invention to provide a composition used for electron blocking layer. Electron blocking layer made from such composition shows excellent effect of reducing dark current level of organic electronic devices. The composition comprises an organic semiconducting polymer and a crosslinking agent, wherein the organic semiconducting polymer and the crosslinking agent can undergo crosslinking reaction under thermal and/or light exposure.

The present invention also provides an organic photodiode, which comprises:
a first electrode,
a second electrode,
an active layer disposed between the first electrode and the second electrode,
a hole blocking layer disposed between the active layer and the second electrode, and
an electron blocking layer disposed between the active layer and the first electrode, wherein the electron blocking layer is made from the composition according to the present invention.

It has been surprisingly found that by using the composition according to the present invention to form the electron blocking layer, organic electronic device comprising such electron blocking layer, such as organic photodiode, has greatly reduced dark current level. Consequently, an organic photodiode comprising said electron blocking layer is energy-efficient and can lead to longer battery life when being used in mobile devices.

### DESCRIPTION OF FIGURES

The present invention will be described with reference to the figures, which are not intended to limit the present invention.

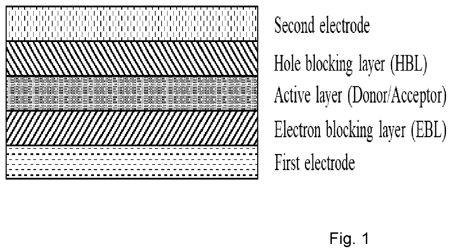

Fig. 1 shows a cross-sectional diagram of layers of an organic photodiode.

### MODE OF CARRYING OUT THE INVENTION

Unless defined otherwise, all technical and scientific terms used herein have the meaning commonly understood by a person skilled in the art to which the invention belongs.

In one aspect, the invention provides a composition which comprises an organic semiconducting polymer and a crosslinking agent, wherein the organic semiconducting polymer and the crosslinking agent can undergo crosslinking reaction under thermal and/or light exposure.

Preferably, the organic semiconducting polymer may be selected from the group consisting of thiophene-based conjugated polymer and diketo-pyrrole-pyrrole (DPP)-based conjugated polymer. More preferably, the organic semiconducting polymer comprises repeating units of the formula 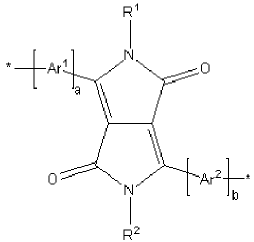 wherein R¹ and R² may be the same or different and are selected from hydrogen, a C₁₋₂₅-alkyl group, an alkenyl group, an alkynyl group, an allyl group, which can be substituted one to three times with C₁₋₄-alkyl; or a cycloalkyl group, which can be substituted one to three times with C₁₋₈-alkyl; a and b are independently of each other an integral number in the range of 0 to 10, Ar¹ and Ar² in each case may be the same or different and independently of each other stand for a group of formula 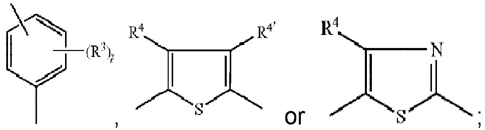
p stands for 0, 1, 2, 3 or 4;
R³ in each case may be the same or different and is selected from C₁₋₂₅-alkyl group or C₁₋₁₈-alkoxy; and
R⁴ and R^{4'} independently from each other stand for hydrogen, C₁₋₂₅-alkyl group or C₁₋₁₈-alkoxy.

In a preferred embodiment, R¹ and R² may be the same or different and are selected from hydrogen, a C₁₋₂₅-alkyl group, an alkenyl group, an alkynyl group, or an allyl group, which can be substituted one to three times with C₁₋₄ alkyl. More preferably, R¹ and R² may be the same or different and are selected from hydrogen, or a C₁₋₂₅-alkyl group. Most preferably, R¹ and R² may be the same or different and stand for a C₅₋₂₅-alkyl group.

In another preferred embodiment, a and b are in the range of 0 to 6, preferably in the range of 1 to 3.

In another preferred embodiment, Ar¹ and Ar² in each case may be the same or different and independently of each other stand for a group of formula

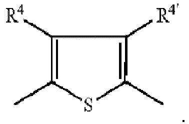

In another preferred embodiment, the organic semiconducting polymer may have the following structure: 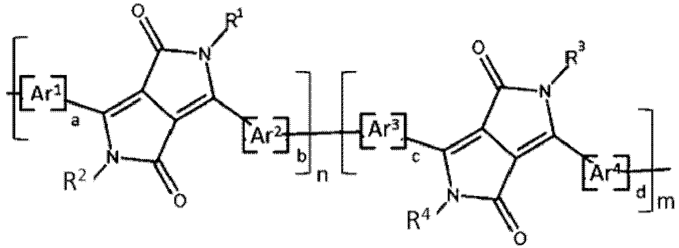
wherein R¹, R², R³ and R⁴ may be the same or different and are selected from hydrogen, a C₁₋₂₅-alkyl group, an alkenyl group, an alkynyl group, an allyl group, which can be substituted one to three times with C₁₋₄-alkyl; or a cycloalkyl group, which can be substituted one to three times with C₁₋₈-alkyl;
Ar¹, Ar², Ar³ and Ar⁴ in each case may be the same or different and independently of each other stand for a group of benzene, substituted benzene, thiophene and substituted thiophene;
a, b, c and d are independently of each other an integral number in the range of 0 to 10, preferably in the range of 1 to 5 and more preferably in the range of 1 to 3; and n is a number in the range of 0.05 to 0.95 and m is a number in the range of 0.95 to 0.05, preferably n is a number in the range of 0.1 to 0.9 and m is a number in the range of 0.9 to 0.1, and more preferably n is a number in the range of 0.15 to 0.85 and m is a number in the range of 0.85 to 0.15.

In another preferred embodiment, the organic semiconducting polymer has the following structure: 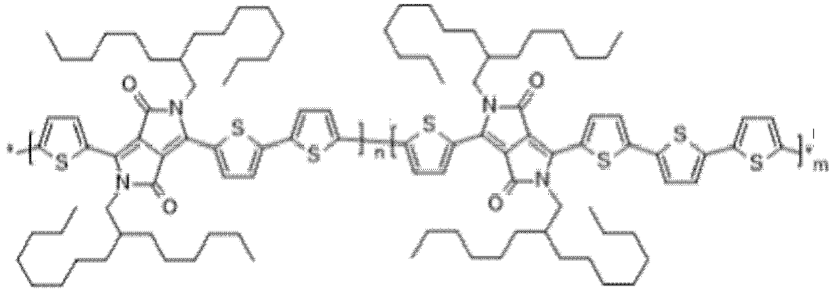 wherein n is a number in the range of 0.05 to 0.95 while m is a number in the range of 0.95 to 0.05. Preferably, n is a number in the range of 0.5 to 0.9 while m is a number in the range of 0.5 to 0.1. More preferably, n is a number in the range of 0.7 to 0.85 while m is a number in the range of 0.3 to 0.15.

Preferably, the crosslinking agent may be selected from the group consisting of diazirine, phenyl azide, fluoro-phenyl azide and acyl azide. Many bisazides may be used, such as 1,6-diazidohexane (DAZH), ethylene bis(4-azido-2,3,5-trifluoro-6isopropylbenzoate) (sFPA), 4,4'-bis(azidomethyl)-1,1'-biphenyl (BABP), 1,2-bis((4-(azidomethyl)phenethyl)thio)ethane (TBA-X), ethylene bis(4-azido-2,3,5,6-tetrafluorobenzoate) (Bis(PFBA)), 3,6-bis(5-(4,4"-bis(3-azidopropyl)-[1,1':3',1"-terphenyl)-5'-yl)thiophen-2-yl)-2,5-bis(2-ethylhexyl)-2,5-dihydropyrrolo(3,4-c)pyrrole-1,4-dione (DPPTPTA), 4-4'-bis(1-azido)undecane)dicyclopenta-(2,1-b:3,4-b')dithiophene-bis(5-fluoro-7-(5'-hexyl-(2,2'-bithiophene)-5-yl)benzo-(c)(1,2,5)thiadiazole) N3-(CPDT(FBTTh2)2), bis(6-azidohexanoate)silicon phthalocyanine (HxN₃)2-SiPc), and tris(4-(5'-(3-azidopropyl)-2,2'- bithiophen5-yl)phenyl)amine (TPT-N₃). More preferably, the crosslinking agent is of formula 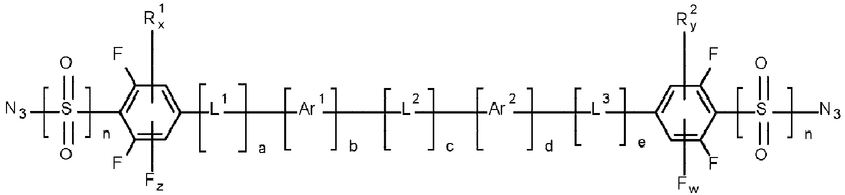 wherein
a is 0, 1 or 2,
b is 1, 2, 3 or 4,
c is 0 or 1 ,
d is 0, 1, 2, 3 or 4,
e is 0, 1 or 2,
x is 0, 1 or 2,
y is 0, 1 or 2,
z is 0, 1 or 2,
w is 0, 1 or 2,
n is 0 or 1,
Ar¹ and Ar² are independently from each other and at each occurrence an aromatic or heteroaromatic moiety, which can be substituted with one or more substituent R^{a} selected from the group consisting of C₁₋₂₀-alkyl, C₅₋₈-cycloalkyl, C₆₋₁₄-aryl, 5 to 12 membered heteroaryl, COOR¹⁰, CONR¹⁰R¹¹, COR¹⁰, SO₃R¹⁰, CN, NO₂, halogen, OR¹⁰, SR¹⁰, NR¹⁰R¹¹, OCOR¹⁰ and NR¹⁰COR¹¹, wherein R¹⁰ and R¹¹ are independently from each other and at each occurrence H, C₁₋₂₀-alkyl, C₅₋₈-cycloalkyl, C₆₋₁₄-aryl or 5 to 12 membered heteroaryl,
wherein C₁₋₂₀-alkyl and C₅₋₈-cycloalkyl can be substituted with one or more substituents R^{aa} at each occurrence selected from the group consisting of phenyl, COOR¹², CONR¹²R¹³, COR¹², SO₃R¹² , CN, NO₂, halogen, OR¹², SR¹², NR¹¹R¹², OCOR¹² and NR¹²COR¹³, wherein C₆₋₁₄-aryl and 5 to 12 membered heteroaryl can be substituted with one or more substituent R^{ab} at each occurrence selected from the group consisting of C₁₋₁₀-alkyl, cyclopentyl, cyclohexyl, COOR¹², CONR¹²R¹³, COR¹², SO₃R¹², CN, NO₂, halogen, OR¹², SR¹², NR¹²R¹³, OCOR¹² and NR¹²COR¹³,
wherein R¹² and R¹³ are independently from each other and at each occurrence C₁₋₁₀-alkyl, cyclopentyl, cyclohexyl or phenyl, and
wherein at least two adjacent Ar¹, at least two adjacent Ar² , and/or Ar¹ and Ar² , both connected to L² or if c = 0 to each other, can be additionally linked by one or more L^{a} , wherein L^{a} is a linking moiety B,
L¹ and L³ are independently from each other and at each occurrence 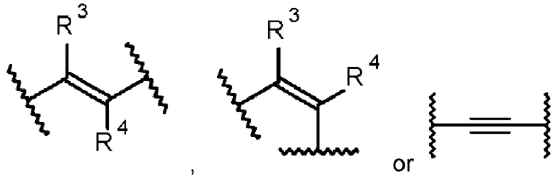 wherein
R³ and R⁴ are independently from each other and at each occurrence H , C₁₋₂₀-alkyl, C₅₋₈-cycloalkyl, C₆₋₁₄-aryl, 5 to 12 membered heteroaryl, COOR²⁰, CONR²⁰R²¹, COR²⁰, SO₃R²⁰, CN, NO₂, or halogen,
wherein R²⁰ and R²¹ are independently from each other and at each occurrence H, C₁₋₂₀-alkyl, C₅₋₈-cycloalkyl, C₆₋₁₄-aryl or 5 to 12 membered heteroaryl,
wherein C₁₋₂₀-alkyl and C₅₋₈-cycloalkyl can be substituted with one or more substituents R^{b} at each occurrence selected from the group consisting of phenyl,
COOR²², CONR²²R²³, COR²², SO₃R²², CN, NO₂, halogen, OR²², SR²², NR²²R²³, OCOR²² and NR²²COR²³,
wherein C₆₋₁₄-aryl and 5 to 12 membered heteroaryl can be substituted with one or more substituent R^{c} at each occurrence selected from the group consisting of C₁₋₁₀-alkyl, cyclopentyl, cyclohexyl, COOR²², CONR²²R²³, COR²², SO₃R²², CN, NO₂, halogen, OR²², SR²², NR²²R²³, OCOR²² and NR²²COR²³,
wherein R²² and R²³ are independently from each other and at each occurrence C₁₋₁₀-alkyl, cyclopentyl, cyclohexyl or phenyl,
or, if L¹ or L³ are 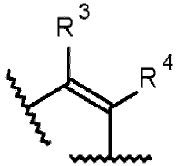
R³ and R⁴ together with the C-atoms to which they are attached form a 5 to 7-membered non-aromatic ring system,
L² is a linking moiety A, and
R¹ and R² are independently from each other and at each occurrence H, C₁₋₂₀-alkyl, C₅₋₈-cycloalkyl, C₆₋₁₄-aryl, 5 to 12 membered heteroaryl, COOR³⁰, CONR³⁰R³¹, COR³⁰, SO₃R³⁰, CN, NO₂, halogen, OR³⁰, SR³⁰, NR³⁰R³¹, OCOR³⁰ or NR³⁰COR³¹, wherein R³⁰ and R³¹ are independently from each other and at each occurrence H, C₁₋₂₀-alkyl, C₅₋₈-cycloalkyl, C₆₋₁₄-aryl or 5 to 12 membered heteroaryl,
wherein C₁₋₂₀-alkyl and C₅₋₈-cycloalkyl can be substituted with one or more substituents R^{d} at each occurrence selected from the group consisting of phenyl, COOR³², CONR³²R³³, COR³², SO₃R³², CN, NO₂, halogen, OR³², SR³², NR³²R³³, OCOR³² and NR³²COR³³,
wherein C₆₋₁₄-aryl and 5 to 12 membered heteroaryl can be substituted with one or more substituent R^{e} at each occurrence selected from the group consisting of C₁₋₁₀-alkyl, cyclopentyl, cyclohexyl, COOR³², CONR³²R³³, COR³², SO₃R³², CN, NO₂, halogen, OR³², SR³², NR³²R³³, OCOR³² and NR³²COR³³,
wherein R³² and R³³ are independently from each other and at each occurrence C₁₋₁₀-alkyl, cyclopentyl, cyclohexyl or phenyl.

Examples of linking moiety A are C₁₋₁₀-alkylene, C₂₋₁₀-alkenylene, C₅₋₈-cycloalkylene, C₁₋₄-alkylene-C₅₋₈-cycloalkylene- C₁₋₄-alkylene, C₁₋₄-alkylene-phenylene- C₁₋₄-alkylene, C₂₋₄-alkenylene-C₅₋₈-cycloalkylene-C₂₋₄-alkenylene and C₂₋₄-alkenylene-phenylene-C₂₋₄-alkenylene, which can be substituted with one or more substitutent R^{f} at each occurrence selected from the group consisting of C₁₋₂₀-alkyl, C₅₋₈-cycloalkyl, C₆₋₁₄-aryl, 5 to 12 membered heteroaryl, COOR⁴⁰, CONR⁴⁰R⁴¹, COR⁴⁰, SO₃R⁴⁰, CN, NO₂, halogen, OR⁴⁰, SR⁴⁰, NR⁴⁰R⁴¹, OCOR⁴⁰ and NR⁴⁰COR⁴¹,
wherein R⁴⁰ and R⁴¹ are independently from each other and at each occurrence H, C₁₋₁₀-alkyl, C₅₋₈-cycloalkyl, C₆₋₁₄-aryl or 5 to 12 membered heteroaryl,
wherein C₁₋₂₀-alkyl and C₅₋₈-cycloalkyl can be substituted with one or more substituents R^{fa} at each occurrence selected from the group consisting of phenyl,
COOR⁴², CONR⁴²R⁴³, COR⁴², SO₃R⁴², CN, NO₂, halogen, OR⁴², SR⁴², NR⁴²R⁴³, OCOR⁴² and NR⁴²COR⁴³,
wherein C₆₋₁₄-aryl and 5 to 12 membered heteroaryl can be substituted with one or more substituent R^{fb} at each occurrence selected from the group consisting of C₁₋₁₀-alkyl, cyclopentyl, cyclohexyl, COOR⁴², CONR⁴²R⁴³, COR⁴², SO₃R⁴², CN, NO₂, halogen, OR⁴², SR⁴², NR⁴²R⁴³, OCOR⁴² and NR⁴²COR⁴³,
wherein R⁴² and R⁴³ are independently from each other and at each occurrence C₁₋₁₀-alkyl, cyclopentyl, cyclohexyl or phenyl, and
wherein one or more CH₂ groups of C₁₋₁₀-alkylene, C₁₋₄-alkylene, C₂₋₁₀-alkenylene, C₂₋₄-alkenylene and/or C₅₋₈-cycloalkylene can be replaced by C=O, (C=O)O, (C=O)NR⁵⁰, SO₂-NR⁵⁰, NR⁵⁰, NR⁵⁰R⁵¹, O or S,
wherein R⁵⁰ and R⁵¹ are independently from each other and at each occurrence C₁₋₁₀-alkyl.

Examples of linking moiety B are C₁₋₄-alkylene, which can be substituted with one or more C₁₋₁₀-alkyl, wherein one or more CH₂ groups of C₁₋₄-alkylene can be replaced by C=O, (C=O)O, (C=O)NR⁶⁰, SO₂-NR⁶⁰, NR⁶⁰, NR⁶⁰R⁶¹, O or S,
wherein R⁶⁰ and R⁶¹ are independently from each other and at each occurrence C₁₋₁₀-alkyl.

In preferred embodiment, the crosslinking agent has the following structure: 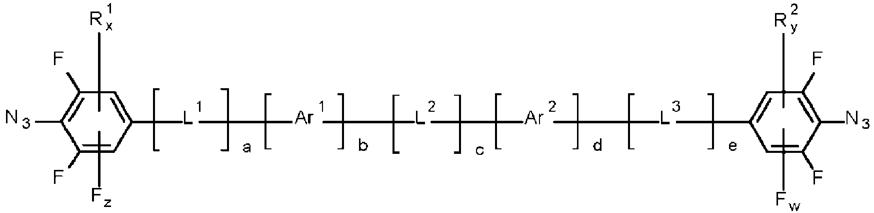 wherein
a is 0, 1 or 2,
b is 1, 2, 3 or 4,
c is 0 or 1 ,
d is 0, 1, 2, 3 or 4,
e is 0, 1 or 2,
x is 0, 1 or 2,
y is 0, 1 or 2,
z is 0, 1 or 2,
w is 0, 1 or 2,
Ar¹ and Ar² are independently from each other and at each occurrence an aromatic or heteroaromatic moiety, which can be substituted with one or more substituent R^{a} selected from the group consisting of C₁₋₂₀-alkyl, C₅₋₈-cycloalkyl, C₆₋₁₄-aryl, 5 to 12 membered heteroaryl, COOR¹⁰, CONR¹⁰R¹¹, COR¹⁰, SO₃R¹⁰, CN, NO₂, halogen, OR¹⁰, SR¹⁰, NR¹⁰R¹¹, OCOR¹⁰ and NR¹⁰COR¹¹, wherein R¹⁰ and R¹¹ are independently from each other and at each occurrence H, C₁₋₂₀-alkyl, C₅₋₈-cycloalkyl, C₆₋₁₄-aryl or 5 to 12 membered heteroaryl,
wherein C₁₋₂₀-alkyl and C₅₋₈-cyclolkyl can be substituted with one or more substituents R^{aa} at each occurrence selected from the group consisting of phenyl, COOR¹², CONR¹²R¹³, COR¹², SO₃R¹², CN, NO₂, halogen, OR¹², SR¹², NR¹¹R¹², OCOR¹² and NR¹²COR¹³, wherein C₆₋₁₄-aryl and 5 to 12 membered heteroaryl can be substituted with one or more substituent R^{ab} at each occurrence selected from the group consisting of C₁₋₁₀-alkyl, cyclopentyl, cyclohexyl, COOR¹², CONR¹²R¹³, COR¹², SO3R¹², CN, NO₂, halogen, OR¹², SR¹², NR¹²R¹³, OCOR¹² and NR¹²COR¹³,
wherein R¹² and R¹³ are independently from each other and at each occurrence C₁₋₁₀-alkyl, cyclopentyl, cyclohexyl or phenyl, and wherein at least two adjacent Ar¹, at least two adjacent Ar², and/or Ar¹ and Ar², both connected to L² or if c = 0 to each other, can be additionally linked by one or more L^{a}, wherein L^{a} is a linking moiety B, L¹ and L³ are independently from each other and at each occurrence 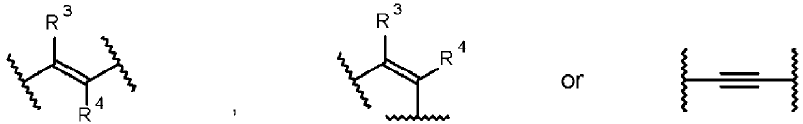
wherein R³ and R⁴ are independently from each other and at each occurrence H, C₁₋₂₀-alkyl, C₅₋₈-cycloalkyl, C₆₋₁₄-aryl, 5 to 12 membered heteroaryl, COOR²⁰, CONR²⁰R²¹, COR²⁰, SO₃R²⁰, CN, NO₂, or halogen,
wherein R²⁰ and R²¹ are independently from each other and at each occurrence H, C₁₋₂₀-alkyl, C₅₋₈-cycloalkyl, C₆₋₁₄-aryl or 5 to 12 membered heteroaryl, wherein C₁₋₂₀-alkyl and C₅₋₈-cycloalkyl can be substituted with one or more substituents R^{b} at each occurrence selected from the group consisting of phenyl, COOR²², CONR²²R²³, COR²², SO₃R²², CN, NO₂, halogen, OR²², SR²², NR²²R²³, OCOR²² and NR²²COR²³, wherein C₆₋₁₄-aryl and 5 to 12 membered heteroaryl can be substituted with one or more substituent R^{c} at each occurrence selected from the group consisting of C₁₋₁₀-alkyl, cyclopentyl, cyclohexyl, COOR²², CONR²²R²³, COR²², SO₃R²², CN, NO₂, halogen, OR²², SR²², NR²²R²³, OCOR²² and NR²²COR²³,
wherein R²² and R²³ are independently from each other and at each occurrence C₁₋₁₀-alkyl, cyclopentyl, cyclohexyl or phenyl, or, if L¹ or L³ are 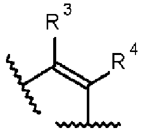
R³ and R⁴ together with the C-atoms to which they are attached form a 5 to 7-membered non-aromatic ring system,
L² is a linking moiety A, and
R¹ and R² are independently from each other and at each occurrence H, C₁₋₂₀-alkyl, C₅₋₈-cycloalkyl, C₆₋₁₄-aryl, 5 to 12 membered heteroaryl, COOR³⁰, CONR³⁰R³¹, COR³⁰, SO₃R³⁰, CN, NO₂, halogen, OR³⁰, SR³⁰, NR³⁰R³¹, OCOR³⁰ or NR³⁰COR³¹, wherein R³⁰ and R³¹ are independently from each other and at each occurrence H, C₁₋₂₀-alkyl, C₅₋₈-cycloalkyl, C₆₋₁₄-aryl or 5 to 12 membered heteroaryl,
wherein C₁₋₂₀-alkyl and C₅₋₈-cycloalkyl can be substituted with one or more substituents R^{d} at each occurrence selected from the group consisting of phenyl, COOR³², CONR³²R³³, COR³², SO₃R³², CN, NO₂, halogen, OR³², SR³², NR³²R³³, OCOR³² and NR²COR³³,
wherein C₆₋₁₄-aryl and 5 to 12 membered heteroaryl can be substituted with one or more substituent R^{e} at each occurrence selected from the group consisting of C₁₋₁₀-alkyl, cyclopentyl, cyclohexyl, COOR³², CONR³²R³³, COR³², SO3R³², CN, NO₂, halogen, OR³², SR³², NR³²R³³, OCOR³² and NR³²COR³³,
wherein R³² and R³³ are independently from each other and at each occurrence C₁₋₁₀-alkyl, cyclopentyl, cyclohexyl or phenyl.

Examples of linking moiety A are C₁₋₁₀-alkylene, C₂₋₁₀-alkenylene, C₅₋₈-cycloalkylene, C₁₋₄-alkylene-C₅₋₈-cycloalkylene- C₁₋₄-alkylene, C₁₋₄-alkylene-phenylene- C₁₋₄-alkylene, C₂₋₄-alkenylene-C₅₋₈-cycloalkylene-C₂₋₄-alkenylene and C₂₋₄-alkenylene-phenylene-C₂₋₄-alkenylene, which can be substituted with one or more substitutent R^{f} at each occurrence selected from the group consisting of C₁₋₂₀-alkyl, C₅₋₈-cycloalkyl, C₆₋₁₄-aryl, 5 to 12 membered heteroaryl, COOR⁴⁰, CONR⁴⁰R⁴¹, COR⁴⁰, SO₃R⁴⁰, CN, NO₂, halogen, OR⁴⁰, SR⁴⁰, NR⁴⁰R⁴¹, OCOR⁴⁰ and NR⁴⁰COR⁴¹,
wherein R⁴⁰ and R⁴¹ are independently from each other and at each occurrence H, C₁₋₁₀-alkyl, C₅₋₈-cycloalkyl, C₆₋₁₄-aryl or 5 to 12 membered heteroaryl,
wherein C₁₋₂₀-alkyl and C₅₋₈-cycloalkyl can be substituted with one or more substituents R^{fa} at each occurrence selected from the group consisting of phenyl,
COOR⁴², CONR⁴²R⁴³, COR⁴², SO₃R⁴², CN, NO₂, halogen, OR⁴², SR⁴², NR⁴²R⁴³, OCOR⁴² and NR⁴²COR⁴³,
wherein C₆₋₁₄-aryl and 5 to 12 membered heteroaryl can be substituted with one or more substituent R^{fb} at each occurrence selected from the group consisting of C₁₋₁₀-alkyl, cyclopentyl, cyclohexyl, COOR⁴², CONR⁴²R⁴³, COR⁴², SO₃R⁴², CN, NO₂, halogen, OR⁴², SR⁴², NR⁴²R⁴³, OCOR⁴² and NR⁴²COR⁴³,
wherein R⁴² and R⁴³ are independently from each other and at each occurrence C₁₋₁₀ alkyl, cyclopentyl, cyclohexyl or phenyl, and
wherein one or more CH₂ groups of C₁₋₁₀-alkylene, C₁₋₄-alkylene, C₂₋₁₀-alkenylene, C₂₋₄-alkenylene and/or C₅₋₈-cycloalkylene can be replaced by C=O, (C=O)O, (C=O)NR⁵⁰, SO₂-NR⁵⁰, NR⁵⁰, NR⁵⁰R⁵¹, O or S,
wherein R⁵⁰ and R⁵¹ are independently from each other and at each occurrence C₁₋₁₀ alkyl.

Examples of linking moiety B are C₁₋₄-alkylene, which can be substituted with one or more C₁₋₁₀-alkyl, wherein one or more CH₂ groups of C₁₋₄-alkylene can be replaced by C=O, (C=O)O, (C=O)NR⁶⁰, SO₂-NR⁶⁰, NR⁶⁰, NR⁶⁰R⁶¹, O or S,
wherein R⁶⁰ and R⁶¹ are independently from each other and at each occurrence C₁₋₁₀ alkyl.

The crosslinking agent can be used in an amount of 0.12 to 4% by weight, based on the total weight of the composition. Preferably, the crosslinking agent is used in an amount of 0.15 to 3.5% by weight, based on the total weight of the composition. More preferably, the crosslinking agent is used in an amount of 0.15 to 3.2% by weight, based on the total weight of the composition.

The composition may optionally comprise an organic solvent. Suitable organic solvent may be selected from the group consisting of volatile organic solvent, such as toluene, xylene, mesitylene, etc.

The composition shows good solvent resistance against solvent commonly used in fabrication of organic electronic device, such as acetone, propylene glycol methyl ether acetate (PGMEA), toluene, xylene, mesitylene, dichlorobenzene and dichloromethane. Thus, it enables using a wide range of solvents for the active layer. Moreover, since the composition is photo-patternable, the electron blocking layer can be fabricated into sophisticated structure through a simple process.

The present invention also provides an organic photodiode, which comprises:
a first electrode,
a second electrode,
an active layer disposed between the first electrode and the second electrode,
a hole blocking layer disposed between the active layer and the second electrode, and
an electron blocking layer disposed between the active layer and the first electrode, wherein the electron blocking layer is made from the composition as described above.

In one embodiment, the electron blocking layer may have a thickness in the range of 70 nm to 300 nm, preferably in the range of 80 nm to 250 nm, and more preferably in the range of 90 nm to 200 nm.

The above definitions and description concerning the composition also apply to the electron blocking layer.

The electron blocking layer can be fabricated by spin coating, blade coating, inkjet printing, gravure printing, slot-die coating and screen printing or photolithography process, or other suitable coating methods which are known in the art.

The active layer is composed of electron donor material and electron acceptor material, which form bulk heterojunction. Electron donor materials are p-type organic semiconductor materials, including at least one of thiophene-based conjugated polymer and diketo-pyrrole-pyrrole (DPP)-based conjugated polymer. Electron acceptor materials include at least one of C60 and fullerene derivatives.

Preferably, the electron donor material of the active layer is the same as the organic semiconducting polymer of the electron blocking layer, so that the active layer has a HOMO level similar to that of the electron blocking layer, which leads to a reduced energy barrier and thus a higher sensitivity of the photodiode, and also reduced dark current level.

Hole blocking layer may be formed by a material known as having hole blocking effect, such as a material selected from the group consisting of Tris-(8-hydroxyquinoline) aluminum (Alq3), Bis(8-hydroxy-2-methylquinoline)-(4-phenylphenoxy)aluminum (BAIq3), 2,2',2"-(1,3,5-Benzinetriyl)-tris(1-phenyl-1-H-benzimidazole) (TPBi), Bathocuproine (BCP), Bathophenanthroline (Bphen), 8-Hydroxyquinolinolato-lithium (Liq), TiO₂ and ZnO.

The first electrode may be formed from, for example, ITO, IZO, FTO, ZnO and the like. The second electrode may be formed from, for example, Al, Mg, Li, Al-Li, Mg-ln and the like. The materials for forming the first and second electrodes are known and can be selected by those skilled in the art.

By incorporating an electron blocking layer made from the composition according to the present invention, the organic photodiode may have a dark current level of about 0.1 to 1 nA/cm², similar to inorganic photodiodes.

The present invention will now be described with reference to the following examples, which are not intended to limit the present invention.

### Example

### Starting materials:

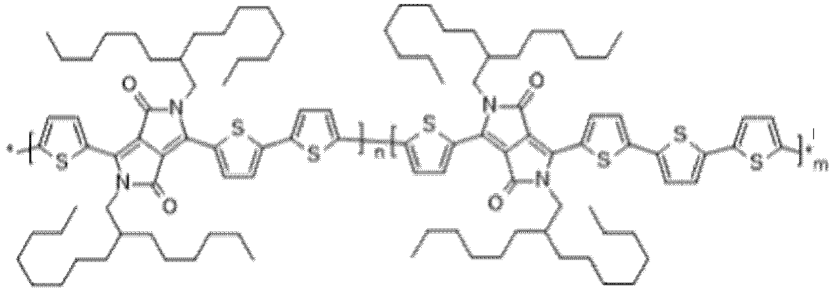

P3000, from BASF, wherein n=0.8, m=0.2 and the polymer has a weight average molecular weight of 50 kDa (measured by GPC against Polystyrene standard in THF). 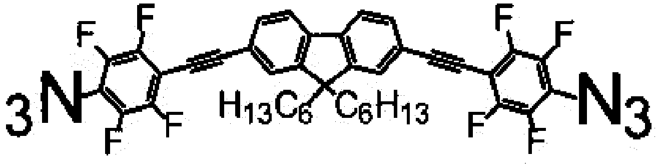 BAZI, from BASF.

BCP, from Sigma-Aldrich.

P3HT (Poly(3-hexylthiophene-2,5-diyl)) and PCBM ([6,6]-phenyl-C61-butyric acid methyl ester), from Sigma-Aldrich.

Al, from iTASCO.

### Test Methods:

Dark current was determined by Keithley 4200, two channel system in black box.

### Preparation of the composition and the organic photodiode:

ITO substrate (first electrode, designed by BASF with active area of 0.09 cm², made by AMG) was cleaned in sonication bath with DI water, acetone and isopropyl alcohol, and then treated with oxygen plasma to remove residue particles. Electron blocking layer material was prepared by dissolving certain amount of organic semiconducting polymer (according to table 1) and crosslinking agent (according to table 1) in 10 ml xylene. Electron blocking layer material was then coated on the substrate using spin coater at a speed of 900 rpm for 30 sec, and subjected to soft bake at 90 °C for 2 minutes. The electron blocking layer had a thickness of 100 nm, which was subjected to UV curing with intensity of 300 mW/cm² at 365nm and thermal annealed at 120 °C for 1 hour to fully crosslinked. Active layer material was prepared by dissolving certain amount of electron donor material (according to table 1) and electron acceptor material (according to table 1) in 10 ml xylene. Active layer material was applied using spin coater at a speed of 400 rpm for 30 sec, followed by soft bake of 90° C for 2 minutes and thermal annealing at 120 °C for 20 minutes. The active layer had a thickness of 100 nm. Hole blocking layer (BCP) was then applied by spin coating at a speed of 1000 rpm for 30 sec on top of the active layer and the hole blocking layer has a thickness less than 10 nm. The second electrode (Al) was deposited through thermal evaporation and the second electrode had a thickness of 100 nm.

Table 1 shows the measured dark current of examples 1 to 12, which are prepared as described above.

**Table 1**

| | Electron Blocking Layer | | Active Layer | | Dark Current (nA/cm²) |
|---|---|---|---|---|---|
| | Organic Semiconducting Polymer (g) | Crosslinking agent (g) | Donor (g) | Acceptor (g) | |
| Ex1 | N.A. | N.A. | P3HT (0.0375) | PCBM (0.0375) | 4.2*10⁴ |
| Ex2 | P3000 (0.125) | BAZI (0.000628) | P3HT (0.0375) | PCBM (0.0375) | 10.8 |
| Ex3 | N.A. | N.A. | P3000 (0.05) | PCBM (0.05) | 6.4 |
| Ex4 | P3000 (0.125) | BAZI (0.000628) | P3000 (0.05) | PCBM (0.05) | 0.23 |
| Ex5 | P3000(0.125) | N.A. | P3000 (0.05) | PCBM (0.05) | 8.3 |
| Ex6 | P3000(0.125) | BAZI (0.000125) | P3000 (0.05) | PCBM (0.05) | 11 |
| Ex7 | P3000(0.125) | BAZI (0.000313) | P3000 (0.05) | PCBM (0.05) | 0.27 |
| Ex8 | P3000(0.125) | BAZI (0.000944) | P3000 (0.05) | PCBM (0.05) | 0.82 |
| Ex9 | P3000(0.125) | BAZI (0.00126) | P3000 (0.05) | PCBM (0.05) | 0.96 |
| Ex10 | P3000(0.125) | BAZI (0.00386) | P3000 (0.05) | PCBM (0.05) | 0.79 |
| Ex11 | P3000(0.125) | BAZI (0.00657) | P3000 (0.05) | PCBM (0.05) | 16 |
| Ex12 | P3000(0.125) | BAZI (0.0138) | P3000 (0.05) | PCBM (0.05) | 18 |

From the table, it can be seen that when a composition comprising an organic semiconducting polymer and a crosslinking agent is used in the electronic blocking layer, dark current of the organic photodiode can be reduced. Moreover, when the amount of crosslinking agent is in the range 0.12 to 4% by weight, based on the total weight of the composition, the dark current can be controlled to a very low level.

In order to know the effect of the thickness of the electron blocking layer on the dark current of the photodiode, Example 4 was repeated, with the thickness of the electron blocking layer varied by changing the spin coating speed.

**Table 2**

| | Spin Coating Speed (rpm) | Electron Blocking Layer thickness (nm) | Dark Current (nA/cm²) |
|---|---|---|---|
| Ex4 | 900 | 100 | 0.23 |
| Ex4-1 | 350 | 150 | 0.21 |
| Ex4-2 | 2500 | 50 | 4.05 |

It is obvious that when the thickness of the electron blocking layer decreases to 50 nm, dark current level increases rapidly. Thus, for achieving better effect of inhibiting dark current, it is preferred to use higher thickness of the electron blocking layer.

## Claims

1. A composition, comprising an organic semiconducting polymer and a crosslinking agent, wherein the organic semiconducting polymer and the crosslinking agent can undergo crosslinking reaction under thermal and/or light exposure.

2. The composition according to claim 1, wherein the organic semiconducting polymer is selected from the group consisting of thiophene-based conjugated polymer and diketo-pyrrole-pyrrole (DPP)-based conjugated polymer.

3. The composition according to claim 1, wherein the organic semiconducting polymer comprises repeating units of the formula 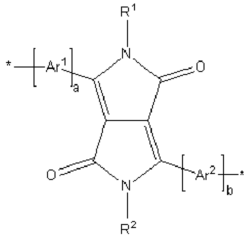
wherein R¹ and R² may be the same or different and are selected from hydrogen, a C₁₋₂₅-alkyl group, an alkenyl group, an alkynyl group, an allyl group, which can be substituted one to three times with C₁₋₄-alkyl; or a cycloalkyl group, which can be substituted one to three times with C₁₋₈-alkyl;
a and b are independently of each other an integral number in the range of 0 to 10, Ar¹ and Ar² in each case may be the same or different and independently of each other stand for a group of formula 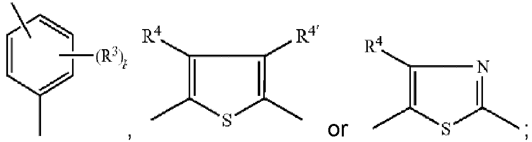
p stands for 0, 1, 2, 3 or 4;
R³ in each case may be the same or different and is selected from C₁₋₂₅-alkyl group or C₁₋₁₈-alkoxy; and
R⁴ and R^{4'} independently from each other stand for hydrogen, C₁-C₂₅ alkyl group or C₁-C₁₈ alkoxy.

4. The composition according to claim 1, wherein the organic semiconducting polymer have the following structure: 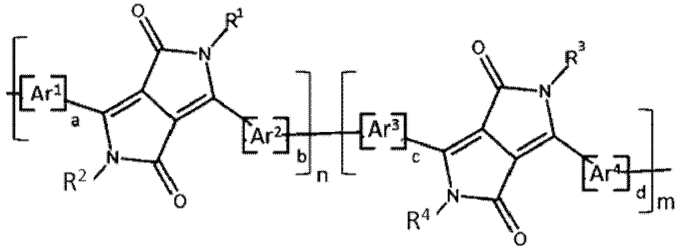
wherein R¹, R², R³ and R⁴ may be the same or different and are selected from hydrogen, a C₁₋₂₅-alkyl group, an alkenyl group, an alkynyl group, an allyl group, which can be substituted one to three times with C₁₋₄-alkyl; or a cycloalkyl group, which can be substituted one to three times with C₁₋₈-alkyl;
Ar¹, Ar², Ar³ and Ar⁴ in each case may be the same or different and independently of each other stand for a group of benzene, substituted benzene, thiophene and substituted thiophene;
a, b, c and d are independently of each other an integral number in the range of 0 to 10, preferably in the range of 1 to 5 and more preferably in the range of 1 to 3; and n is a number in the range of 0.05 to 0.95 and m is a number in the range of 0.95 to 0.05, preferably n is a number in the range of 0.1 to 0.9 and m is a number in the range of 0.9 to 0.1, and more preferably n is a number in the range of 0.15 to 0.85 and m is a number in the range of 0.85 to 0.15.

5. The composition according to claim 1, wherein the organic semiconducting polymer has the following structure: 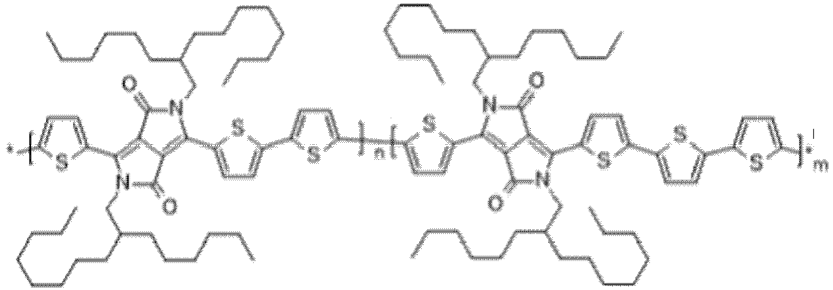 wherein n is a number in the range of 0.05 to 0.95 while m is a number in the range of 0.95 to 0.05; preferably, n is a number in the range of 0.5 to 0.9 while m is a number in the range of 0.5 to 0.1; more preferably, n is a number in the range of 0.7 to 0.85 while m is a number in the range of 0.3 to 0.15.

6. The composition according to claim 5, wherein n=0.8 and m=0.2.

7. The composition according to claim 1, wherein the crosslinking agent is selected from the group consisting of diazirine, phenyl azide, fluoro-phenyl azide and acyl azide.

8. The composition according to claim 1, wherein the crosslinking agent is of formula 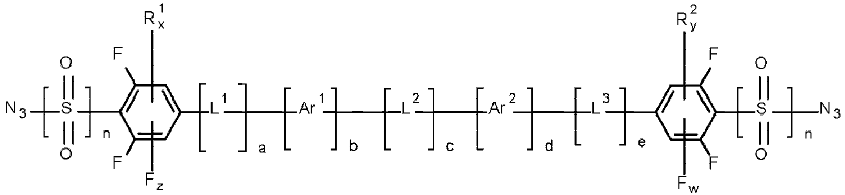 wherein
a is 0, 1 or 2,
b is 1 , 2, 3 or 4,
c is 0 or 1 ,
d is 0, 1 , 2, 3 or 4,
e is 0, 1 or 2,
x is 0, 1 or 2,
y is 0, 1 or 2,
z is 0, 1 or 2,
w is 0, 1 or 2,
n is 0 or 1,
Ar¹ and Ar² are independently from each other and at each occurrence an aromatic or heteroaromatic moiety, which can be substituted with one or more substituent R^{a} selected from the group consisting of C₁₋₂₀-alkyl, C₅₋₈-cycloalkyl, C₆₋₁₄-aryl, 5 to 12 membered heteroaryl, COOR¹⁰, CONR¹⁰R¹¹, COR¹⁰, SO₃R¹⁰, CN, NO₂, halogen, OR¹⁰, SR¹⁰, NR¹⁰R¹¹, OCOR¹⁰ and NR¹⁰COR¹¹, wherein R¹⁰ and R¹¹ are independently from each other and at each occurrence H, C₁₋₂₀-alkyl, C₅₋₈-cycloalkyl, C₆₋₁₄-aryl or 5 to 12 membered heteroaryl,
wherein C₁₋₂₀-alkyl and C₅₋₈-cycloalkyl can be substituted with one or more substituents R^{aa} at each occurrence selected from the group consisting of phenyl, COOR¹², CONR¹²R¹³, COR¹², SO₃R¹², CN, NO₂, halogen, OR¹², SR¹², NR¹¹R¹², OCOR¹² and NR¹²COR¹³, wherein C₆₋₁₄-aryl and 5 to 12 membered heteroaryl can be substituted with one or more substituent R^{ab} at each occurrence selected from the group consisting of C₁₋₁₀-alkyl, cyclopentyl, cyclohexyl, COOR¹², CONR¹²R¹³, COR¹², SO₃R¹², CN, NO₂, halogen, OR¹², SR¹², NR¹²R¹³, OCOR¹² and NR¹²COR¹³,
wherein R¹² and R¹³ are independently from each other and at each occurrence C₁₋₁₀ alkyl, cyclopentyl, cyclohexyl or phenyl, and
wherein at least two adjacent Ar¹, at least two adjacent Ar² , and/or Ar¹ and Ar² , both connected to L² or if c = 0 to each other, can be additionally linked by one or more L^{a}
, wherein L^{a} is a linking moiety B,
L¹ and L³ are independently from each other and at each occurrence 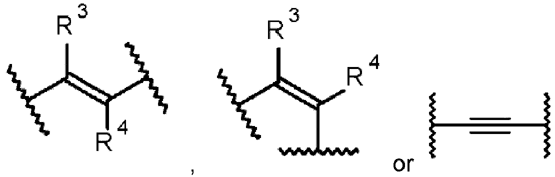 wherein
R³ and R⁴ are independently from each other and at each occurrence H , C₁₋₂₀-alkyl, C₅₋₈-cycloalkyl, C₆₋₁₄-aryl, 5 to 12 membered heteroaryl, COOR²⁰, CONR²⁰R²¹, COR²⁰, SO₃R²⁰, CN, NO₂, or halogen,
wherein R²⁰ and R²¹ are independently from each other and at each occurrence H, C₁₋₂₀-alkyl, C₅₋₈-cycloalkyl, C₆₋₁₄-aryl or 5 to 12 membered heteroaryl,
wherein C₁₋₂₀-alkyl and C₅₋₈-cycloalkyl can be substituted with one or more substituents R^{b} at each occurrence selected from the group consisting of phenyl, COOR²², CONR²²R²³, COR²², SO₃R²², CN, NO₂, halogen, OR²², SR²², NR²²R²³, OCOR²² and NR²²COR²³,
wherein C₆₋₁₄-aryl and 5 to 12 membered heteroaryl can be substituted with one or more substituent R^{c} at each occurrence selected from the group consisting of C₁₋₁₀-alkyl, cyclopentyl, cyclohexyl, COOR²², CONR²²R²³, COR²², SO₃R²², CN, NO₂, halogen, OR²², SR²², NR²²R²³, OCOR²² and NR²²COR²³,
wherein R²² and R²³ are independently from each other and at each occurrence C₁₋₁₀ alkyl, cyclopentyl, cyclohexyl or phenyl,
or, if L¹ or L³ are 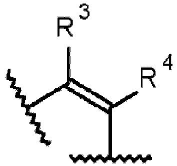
R³ and R⁴ together with the C-atoms to which they are attached form a 5 to 7-membered non-aromatic ring system,
L² is a linking moiety A, and
R¹ and R² are independently from each other and at each occurrence H, C₁₋₂₀-alkyl, C₅₋₈-cycloalkyl, C₆₋₁₄-aryl, 5 to 12 membered heteroaryl, COOR³⁰, CONR³⁰R³¹, COR³⁰, SO₃R³⁰, CN, NO₂, halogen, OR³⁰, SR³⁰, NR³⁰R³¹, OCOR³⁰ or NR³⁰COR³¹, wherein R³⁰ and R³¹ are independently from each other and at each occurrence H, C₁₋₂₀-alkyl, C₅₋₈-cycloalkyl, C₆₋₁₄-aryl or 5 to 12 membered heteroaryl,
wherein C₁₋₂₀-alkyl and C₅₋₈-cycloalkyl can be substituted with one or more substituents R^{d} at each occurrence selected from the group consisting of phenyl, COOR³², CONR³²R³³, COR³², SO₃R³², CN, NO₂, halogen, OR³², SR³², NR³²R³³, OCOR³² and NR³²COR³³,
wherein C₆₋₁₄-aryl and 5 to 12 membered heteroaryl can be substituted with one or more substituent R^{e} at each occurrence selected from the group consisting of C₁₋₁₀-alkyl, cyclopentyl, cyclohexyl, COOR³², CONR³²R³³, COR³², SO₃R³², CN, NO₂, halogen, OR³², SR³², NR³²R³³, OCOR³² and NR³²COR³³,
wherein R³² and R³³ are independently from each other and at each occurrence C₁₋₁₀ alkyl, cyclopentyl, cyclohexyl or phenyl;
wherein linking moiety A is selected from the group consisting of C₁₋₁₀-alkylene, C₂₋₁₀-alkenylene, C₅₋₈-cycloalkylene, C₁₋₄-alkylene-C₅₋₈-cycloalkylene-C₁₋₄-alkylene, C₁₋₄-alkylene-phenylene-C₁₋₄-alkylene, C₂₋₄-alkenylene-C₅₋₈-cycloalkylene- C₂₋₄-alkenylene and C₂₋₄-alkenylene-phenylene-C₂₋₄-alkenylene, which can be substituted with one or more substitutent R^{f} at each occurrence selected from the group consisting of C₁₋₂₀-alkyl, C₅₋₈-cycloalkyl, C₆₋₁₄-aryl, 5 to 12 membered heteroaryl, COOR⁴⁰, CONR⁴⁰R⁴¹, COR⁴⁰, SO₃R⁴⁰, CN, NO₂, halogen, OR⁴⁰, SR⁴⁰, NR⁴⁰R⁴¹, OCOR⁴⁰ and NR⁴⁰COR⁴¹, wherein R⁴⁰ and R⁴¹ are independently from each other and at each occurrence H, C₁₋₁₀-alkyl, C₅₋₈-cycloalkyl, C₆₋₁₄-aryl or 5 to 12 membered heteroaryl,
wherein C₁₋₂₀-alkyl and C₅₋₈-cycloalkyl can be substituted with one or more substituents R^{fa} at each occurrence selected from the group consisting of phenyl, COOR⁴², CONR⁴²R⁴³, COR⁴², SO₃R⁴², CN, NO₂, halogen, OR⁴², SR⁴², NR⁴²R⁴³, OCOR⁴² and NR⁴²COR⁴³,
wherein C₆₋₁₄-aryl and 5 to 12 membered heteroaryl can be substituted with one or more substituent R^{fb} at each occurrence selected from the group consisting of C₁₋₁₀-alkyl, cyclopentyl, cyclohexyl, COOR⁴², CONR⁴²R⁴³, COR⁴², SO₃R⁴², CN, NO₂, halogen, OR⁴², SR⁴², NR⁴²R⁴³, OCOR⁴² and NR⁴²COR⁴³,
wherein R⁴² and R⁴³ are independently from each other and at each occurrence C₁₋₁₀ alkyl, cyclopentyl, cyclohexyl or phenyl, and
wherein one or more CH₂ groups of C₁₋₁₀-alkylene, C₁₋₄-alkylene, C₂₋₁₀-alkenylene, C₂₋₄-alkenylene and/or C₅₋₈-cycloalkylene can be replaced by C=O, (C=O)O, (C=O)NR⁵⁰, SO₂-NR⁵⁰, NR⁵⁰, NR⁵⁰R⁵¹, O or S,
wherein R⁵⁰ and R⁵¹ are independently from each other and at each occurrence C₁₋₁₀ alkyl; and
wherein linking moiety B is C₁₋₄-alkylene, which can be substituted with one or more C₁₋₁₀-alkyl, wherein one or more CH₂ groups of C₁₋₄-alkylene can be replaced by C=O, (C=O)O, (C=O)NR⁶⁰, SO₂-NR⁶⁰, NR⁶⁰, NR⁶⁰R⁶¹, O or S,
wherein R⁶⁰ and R⁶¹ are independently from each other and at each occurrence C₁₋₁₀ alkyl.

9. The composition according to claim 1, wherein the crosslinking agent has the following structure: 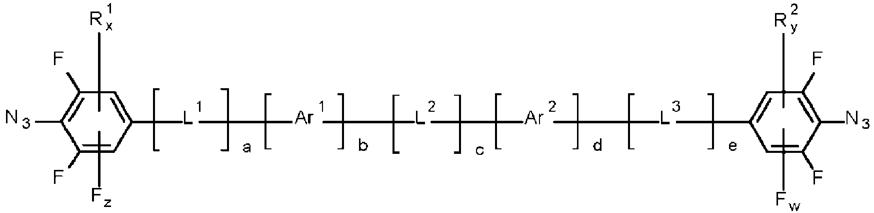
wherein a is 0, 1 or 2,
b is 1, 2, 3 or 4,
c is 0 or 1 ,
d is 0, 1, 2, 3 or 4,
e is 0, 1 or 2,
x is 0, 1 or 2,
y is 0, 1 or 2,
z is 0, 1 or 2,
w is 0, 1 or 2,
Ar¹ and Ar² are independently from each other and at each occurrence an aromatic or heteroaromatic moiety, which can be substituted with one or more substituent R^{a} selected from the group consisting of C₁₋₂₀-alkyl, C₅₋₈-cycloalkyl, C₆₋₁₄-aryl, 5 to 12 membered heteroaryl, COOR¹⁰, CONR¹⁰R¹¹, COR¹⁰, SO₃R¹⁰, CN, NO₂, halogen, OR¹⁰, SR¹⁰, NR¹⁰R¹¹, OCOR¹⁰ and NR¹⁰COR¹¹, wherein R¹⁰ and R¹¹ are independently from each other and at each occurrence H, C₁₋₂₀-alkyl, C₅₋₈-cycloalkyl, C₆₋₁₄-aryl or 5 to 12 membered heteroaryl,
wherein C₁₋₂₀-alkyl and C₅₋₈-cyclolkyl can be substituted with one or more substituents R^{aa} at each occurrence selected from the group consisting of phenyl, COOR¹², CONR¹²R¹³, COR¹², SO₃R¹², CN, NO₂, halogen, OR¹², SR¹², NR¹¹R¹², OCOR¹² and NR¹²COR¹³, wherein C₆₋₁₄-aryl and 5 to 12 membered heteroaryl can be substituted with one or more substituent R^{ab} at each occurrence selected from the group consisting of C₁₋₁₀-alkyl, cyclopentyl, cyclohexyl, COOR¹², CONR¹²R¹³, COR¹², SO3R¹², CN, NO₂, halogen, OR¹², SR¹², NR¹²R¹³, OCOR¹² and NR¹²COR¹³,
wherein R¹² and R¹³ are independently from each other and at each occurrence C₁₋₁₀-alkyl, cyclopentyl, cyclohexyl or phenyl, and wherein at least two adjacent Ar¹, at least two adjacent Ar², and/or Ar¹ and Ar², both connected to L² or if c = 0 to each other, can be additionally linked by one or more L^{a}, wherein L^{a} is a linking moiety B, L¹ and L³ are independently from each other and at each occurrence 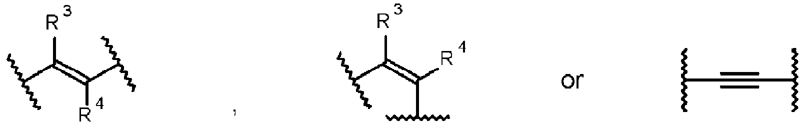
wherein R³ and R⁴ are independently from each other and at each occurrence H, C₁₋₂₀-alkyl, C₅₋₈-cycloalkyl, C₆₋₁₄-aryl, 5 to 12 membered heteroaryl, COOR²⁰, CONR²⁰R²¹, COR²⁰, SO₃R²⁰, CN, NO₂, or halogen,
wherein R²⁰ and R²¹ are independently from each other and at each occurrence H, C₁₋₂₀-alkyl, C₅₋₈-cycloalkyl, C₆₋₁₄-aryl or 5 to 12 membered heteroaryl, wherein C₁₋₂₀-alkyl and C₅₋₈-cycloalkyl can be substituted with one or more substituents R^{b} at each occurrence selected from the group consisting of phenyl, COOR²², CONR²²R²³, COR²², SO₃R²², CN, NO₂, halogen, OR²², SR²², NR²²R²³, OCOR²² and NR²²COR²³, wherein C₆₋₁₄-aryl and 5 to 12 membered heteroaryl can be substituted with one or more substituent R^{c} at each occurrence selected from the group consisting of C₁₋₁₀-alkyl, cyclopentyl, cyclohexyl, COOR²², CONR²²R²³, COR²², SO₃R²², CN, NO₂, halogen, OR²², SR²², NR²²R²³, OCOR²² and NR²²COR²³,
wherein R²² and R²³ are independently from each other and at each occurrence C₁₋₁₀-alkyl, cyclopentyl, cyclohexyl or phenyl, or, if L¹ or L³ are 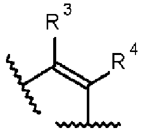
R³ and R⁴ together with the C-atoms to which they are attached form a 5 to 7-membered non-aromatic ring system,
L² is a linking moiety A, and
R¹ and R² are independently from each other and at each occurrence H, C₁₋₂₀-alkyl, C₅₋₈-cycloalkyl, C₆₋₁₄-aryl, 5 to 12 membered heteroaryl, COOR³⁰, CONR³⁰R³¹, COR³⁰, SO₃R³⁰, CN, NO₂, halogen, OR³⁰, SR³⁰, NR³⁰R³¹, OCOR³⁰ or NR³⁰COR³¹, wherein R³⁰ and R³¹ are independently from each other and at each occurrence H, C₁₋₂₀-alkyl, C₅₋₈-cycloalkyl, C₆₋₁₄-aryl or 5 to 12 membered heteroaryl,
wherein C₁₋₂₀-alkyl and C₅₋₈-cycloalkyl can be substituted with one or more substituents R^{d} at each occurrence selected from the group consisting of phenyl, COOR³², CONR³²R³³, COR³², SO₃R³², CN, NO₂, halogen, OR³², SR³², NR³²R³³, OCOR³² and NR²COR³³,
wherein C₆₋₁₄-aryl and 5 to 12 membered heteroaryl can be substituted with one or more substituent R^{e} at each occurrence selected from the group consisting of C₁₋₁₀-alkyl, cyclopentyl, cyclohexyl, COOR³², CONR³²R³³, COR³², SO₃R³², CN, NO₂, halogen, OR³², SR³², NR³²R³³, OCOR³² and NR³²COR³³,
wherein R³² and R³³ are independently from each other and at each occurrence C₁₋₁₀-alkyl, cyclopentyl, cyclohexyl or phenyl,
wherein linking moiety A is selected from the group consisting of C₁₋₁₀-alkylene, C₂₋₁₀-alkenylene, C₅₋₈-CyCloalkylene, C₁₋₄-alkylene-C₅₋₈-CyCloalkylene- C₁₋₄-alkylene, C₁₋₄-alkylene-phenylene-C₁₋₄-alkylene, C₂₋₄-alkenylene-C₅₋₈-cycloalkylene- C2-4-alkenylene and C₂₋₄-alkenylene-phenylene-C₂₋₄-alkenylene, which can be substituted with one or more substitutent R^{f} at each occurrence selected from the group consisting of C₁₋₂₀-alkyl, C₅₋₈-cycloalkyl, C₆₋₁₄-aryl, 5 to 12 membered heteroaryl, COOR⁴⁰, CONR⁴⁰R⁴¹, COR^{40,} SO₃R₄₀, CN, NO₂, halogen, OR⁴⁰, SR⁴⁰, NR⁴⁰R⁴¹, OCOR⁴⁰ and NR⁴⁰COR⁴¹, wherein R⁴⁰ and R⁴¹ are independently from each other and at each occurrence H, C₁₋₁₀-alkyl, C₅₋₈-cycloalkyl, C₆₋₁₄-aryl or 5 to 12 membered heteroaryl,
wherein linking moiety B is C₁₋₄-alkylene, which can be substituted with one or more C₁₋₁₀-alkyl, wherein one or more CH₂ groups of C₁₋₄-alkylene can be replaced by C=O, (C=O)O, (C=O)NR⁶⁰ , SO₂-NR⁶⁰, NR⁶⁰, NR⁶⁰R⁶¹, O or S,
wherein R⁶⁰ and R⁶¹ are independently from each other and at each occurrence C₁₋₁₀-alkyl.

10. The composition according to claim 9, wherein
R¹ and R² are independently from each other and at each occurrence H, C₁₋₂₀-alkyl, C₅₋₈-cycloalkyl,
L¹ and L³ are independently from each other and at each occurrence 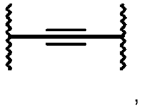 and Ar¹ and Ar² are independently from each other and at each occurrence an aromatic moiety, which can be substituted with one or more substituent R^{a} selected from the group consisting of C₁₋₂₀-alkyl or C₅₋₈-cycloalkyl.

11. The composition according to claim 10, wherein b and e are respectively 1 or 2.

12. The composition according to claim 11, wherein the crosslinking agent has the following structure:

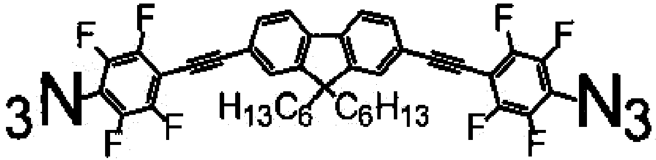

13. The composition according to claim 1, wherein the crosslinking agent is used in an amount of 0.12 to 4% by weight, preferably in an amount of 0.15 to 3.5% by weight, and more preferably in an amount of 0.15 to 3.2% by weight, based on the total weight of the composition.

14. An organic photodiode, comprising:
a first electrode,
a second electrode,
an active layer disposed between the first electrode and the second electrode,
a hole blocking layer disposed between the active layer and the second electrode,
and
an electron blocking layer disposed between the active layer and the first electrode,
wherein the electron blocking layer is made from the composition according to any of claims 1-13.

15. an organic photodiode according to claim 14, wherein the electron blocking layer has a thickness in the range of 70 nm to 300 nm, preferably in the range of 80 nm to 250 nm, and more preferably in the range of 90 nm to 200 nm.
